# EUROPEAN PATENT APPLICATION

(11) **EP 4 718 089 A1**
(43) Date of publication of application: **01.04.2026**
(21) Application number: 25197448.1
(22) Date of filing: 21.08.2025
(51) Int. Cl.: G01R 31/28

(54) **METHODS AND APPARATUS TO DISENGAGE A TEST HEAD FROM AN INTEGRATED CIRCUIT (IC) DEVICE**

(30) Priority: 25.09.2024 US 202418896345
(71) Applicant: INTEL Corporation, Santa Clara, CA 95054 (US)
(72) Inventor: WIENEKE, David Daniel, San Tan Valley, 85143 (US); GIVONI, Izhak, Chandler, 85248 (US); CHANDRA KUMAR, Sriram, Gilbert, 85298 (US)
(74) Representative: HGF

(57) **Abstract**

Methods and apparatus to disengage a test head from an integrated circuit (IC) device are disclosed. An example apparatus comprises a test head to thermally interface with an IC device, a mounting piece to be coupled to the test head, and a push off tab to be mounted to the mounting piece, the push off tab including an arm to extend underneath the test head, the arm to contact the IC device before the test head is to contact the IC device.

## Description

### BACKGROUND

Thermal testing of integrated circuit (IC) packages can evaluate the thermal management and/or long-term reliability of such IC packages. Often times, the equipment performing the thermal testing can affect test results. In some examples, the equipment can inadvertently damage or otherwise affect the IC package itself.

### BRIEF DESCRIPTION OF THE DRAWINGS

FIGS. 1A-1E illustrate an example testing sequence including an example tool system constructed in accordance with examples disclosed herein.
FIGS. 2A-2D illustrate an example first push off tab of the example tool system of FIGS. 1A-1E.
FIG. 3A is a plan view of an example test head, an example mounting piece, and two example first push off tabs of FIGS. 1A-1E.
FIG. 3B is a partial, perspective view of the example test head, the example mounting piece, and one of the example first push off tabs shown in FIG. 3A.
FIG. 4 is an example free body diagram of an example integrated circuit (IC) device of FIGS. 1A-1E.
FIGS. 5A-5D illustrate an example second push off tab that can be implemented in the example tool system of FIGS. 1A-1E.
FIG. 6 is a perspective view of the example mounting piece and the example IC device of FIGS. 1A-1E and two example second push off tabs of FIGS. 5A-5D.
FIGS. 7A-7D illustrate an example third push off tab that can be implemented in the example tool system of FIGS. 1A-1E.
FIGS. 8A-8D illustrate an example fourth push off tab that can be implemented in the example tool system of FIGS. 1A-1E.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

Integrated circuit (IC) devices (e.g., IC packages, semiconductor die(s) in IC packages, etc.) are subjected to a variety of tests after manufacture and before shipping. These tests can ensure the reliability and/or quality of such IC devices under different operation conditions. For example, thermal testing evaluates the electrical performance of an example IC device at hot and/or cold temperatures and/or based on the IC device executing different types of workloads. Typically, thermal testing is performed by a test head that includes a cold plate, a heatsink, and/or other cooling mechanism(s) to dissipate or draw heat away from an associated IC device (e.g., an IC device subject to testing, a device under test (DUT), etc.) executing a workload as part of the thermal test. To enable this thermal transfer during the execution of a thermal test, the test head (e.g., the cold plate, the heatsink, and/or the other cooling mechanism(s)) contacts (e.g., is thermally coupled with) the DUT (e.g., a top surface of the DUT facing the test head). After the test, the test head separates itself from the DUT. However, in some examples, the DUT adheres to the test head as the test head attempts to separate itself. This can result in dislocation of the DUT relative to an associated socket, damage to the DUT, unscheduled downtime of the testing equipment (e.g., as an operator attempts to manually remove the DUT from the test head), etc.

Previous solutions to mitigate adhesion between a test head and a DUT include test head mounted push off plungers and socket mounted retention features. The test head mounted push off plungers include springs and cylindrically shaped bodies positioned on the test head facing the DUT. These plungers are designed to interface with the DUT directly and employ springs to create a reactionary force on the DUT (e.g., to retain the DUT in place by pushing the DUT off of the test head). However, the push off plungers are specifically dimensioned and positioned based on the type/kind of DUT. This limits the variety of DUTs that can be included for testing. Further, the cylindrically shaped bodies prove to be large and/or unwieldy in an otherwise tightly constrained space between the DUT and the test head.

Another previous solution utilizes retention features that are mounted on a socket in which the DUT is placed. These can include spring loaded latches that are initially held in a retracted state. As the test head moves toward and comes into contact with the DUT, the spring loaded latches extend (e.g., horizontally extend) to contact the DUT. In turn, the spring loaded latches retain a position of the DUT adjacent a socket when the test head is drawn away by creating a reactionary force at the points of contact between the latches and the DUT. Similar to the previously described push off plungers, these socket mounted retention features are specifically dimensioned and positioned based on the type/kind/dimensions of a DUT. As such, socket mounted retention features allow for little to no variability in DUT design. This can cause expensive, time-costly rework to redesign the test head setup.

Examples disclosed herein provide example push off tabs that retain a positioning of an example DUT device during thermal testing and/or immediately thereafter (e.g., push or urge a DUT to disengage from a test head as the test head is being removed). For example, as an example test head disengages, separates, etc., from the DUT during an example test, example push off tabs disclosed herein create a reactionary force against any adhesive/capillary forces. As such, examples disclosed herein improve the efficiency of a testing sequence by mitigating manual intervention that is otherwise needed to separate the DUT from the test head. Further, example push off tabs disclosed herein can be quickly and easily replaced on a given test head with different push off tabs of different sizes, shapes, and/or other properties as needed to be used with different types of DUTs having varying dimensions, positions, etc. As such, examples disclosed herein are cost effective and improve the overall efficiency of the testing sequence.

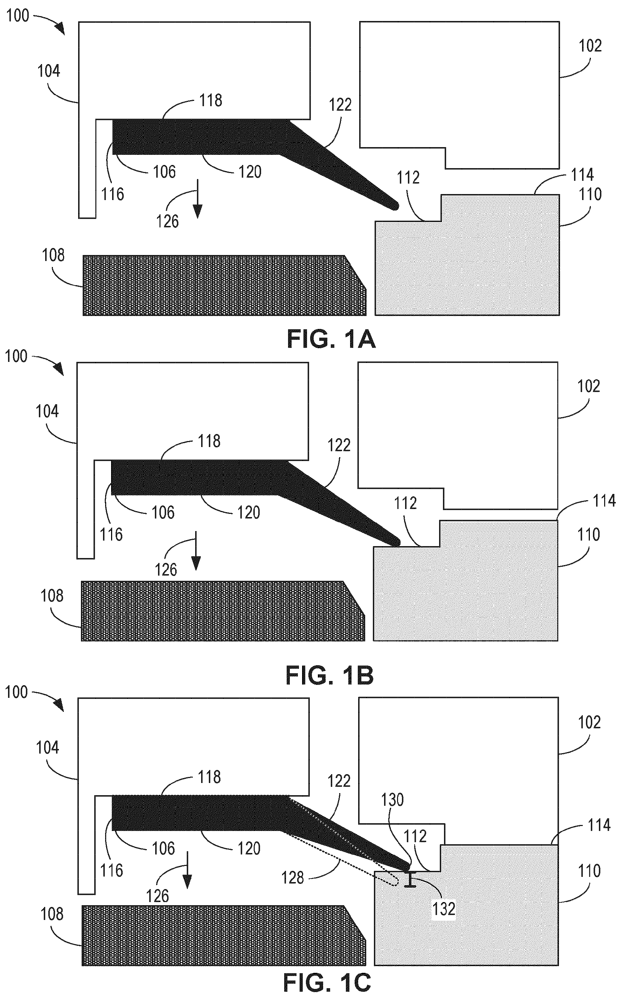

FIGS. 1A-1E illustrate an example testing sequence including an example tool system 100 constructed in accordance with examples disclosed herein. The example tool system 100 includes an example test head 102, an example mounting piece 104 (e.g., plate, tool, etc.), an example first push off tab 106, an example socket 108, and an example DUT 110 (e.g., an IC device under test). The example DUT 110 is positioned within the socket 108. Further, the socket 108 can couple the DUT 110 to a printed circuit board (not shown in FIGS. 1A-1E).

The example mounting piece 104 and the example test head 102 are tools to facilitate a thermal test as shown in the testing sequence of FIGS. 1A-1E. In some examples, the mounting piece 104 is coupled to the test head 102. In some examples, the mounting piece 104 is movable with the test head 102. For example, the mounting piece 104 and the test head 102 can move in unison, in sequence, etc., with one another. Put differently, the example test head 102 is movable to thermally couple to the DUT 110, and the mounting piece 104 is movable towards the socket 108. In some examples, the mounting piece 104 remains spaced apart from the socket 108 when the test head 102 is in contact with the DUT 110

In some examples, the DUT 110 includes an integrated heat spreader (IHS) over top of one or more semiconductor dies. In such examples, the IHS defines an upper surface (e.g., an example second surface 114) of the DUT 110 that directly interfaces with (e.g., contacts) the test head 102. The example test head 102 interfaces with the DUT 110 during the testing sequence of FIGS. 1A-1E. In some examples, the DUT 110 includes a bare die (e.g., no IHS) such that the upper surface (e.g., the second surface 114) of the DUT 110 is an outer surface of the bare die. The example DUT 110 (e.g., an IHS included with the DUT 110) includes an example first surface 112 and the second surface 114. The example first surface 112 is recessed relative to the second surface 114. In examples where the DUT 110 includes a bare die, the second surface 114 can be defined by a package substrate supporting the die or a stiffener on such a substrate. The example test head 102 interfaces with the second surface 114, as described in detail in connection with at least FIG. 1C.

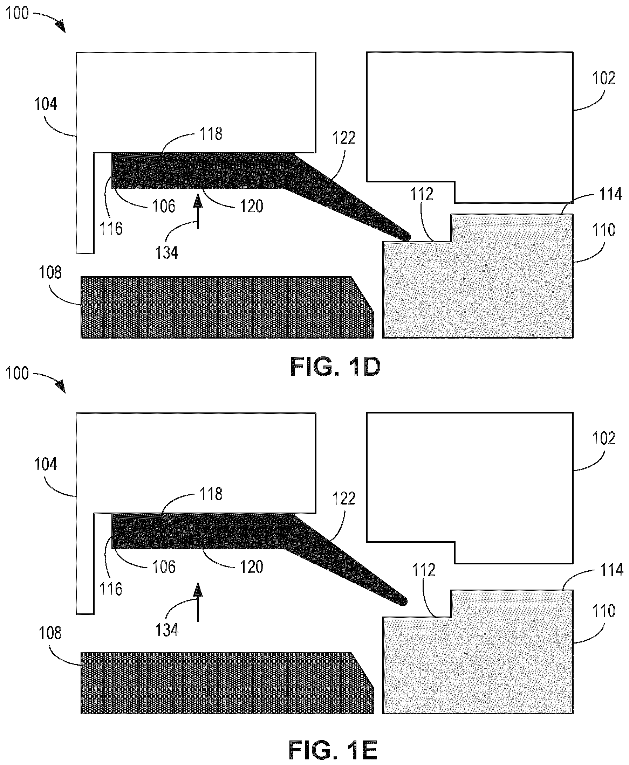

The example first push off tab 106 is mounted to and/or supported by the mounting piece 104. As such, the example first push off tab 106 is movable with the mounting piece 104 (e.g., along an up and down direction) and the test head 102. However, the example first push off tab 106 is removably coupled to the mounting piece 104. Accordingly, the example first push off tab 106 can be positioned, moved, replaced, etc., at different locations on the mounting piece 104. In the example of FIG. 1, there is only the first push off tab 106. However, any number of the first push off tab 106 or any number of example push off tabs disclosed herein may be included in the testing sequence of FIGS. 1A-1E.

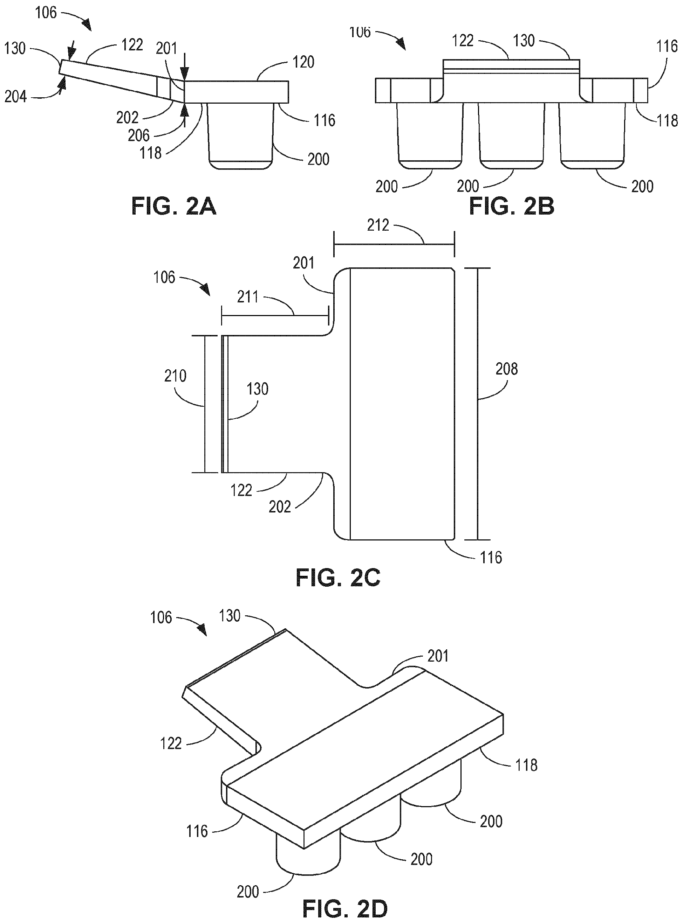

The example first push off tab 106 includes an example body 116 (e.g., tab body, base, tab base, etc.) to interface with the mounting piece 104. The example body 116 is coupled to the mounting piece 104 to attach the first push off tab 106 thereto. In particular, the example body 116 includes a third surface 118 in contact with the mounting piece 104 and a fourth surface 120 facing away from the mounting piece 104 (e.g., towards the socket 108). Further, the example first push off tab 106 includes an example arm 122 (e.g., protrusion, cantilever, cantilevered arm, etc.) extending from an example first side 201 (FIGS. 2A, 2C, 2D) of the body 116 towards the DUT 110. Further, the example arm 122 extends underneath the test head 102.

Turning to FIG. 1A, the example tool system 100 is shown in a first or initial position. The example test head 102 is spaced apart from the DUT 110. Further, the example mounting piece 104 is spaced apart from the socket 108. In the first position of FIG. 1A, the example test head 102 has not yet engaged with the DUT 110. However, the example test head 102 and the mounting piece 104 are movable along a direction indicated by arrow 126 towards the socket 108 (e.g., so that the test head 102 can engage with the DUT 110).

In FIG. 1B, the example tool system 100 is shown in a second or intermediate position. The example test head 102 and the example mounting piece 104 have moved in the direction indicated by the arrow 126. As shown in FIG. 1B, the example arm 122 of the first push off tab 106 contacts the first surface 112 of the DUT 110. However, at this position, the example test head 102 remains spaced apart from the DUT 110. Further, the example mounting piece 104 is spaced apart from the socket 108. Thus, the example arm 122 contacts the DUT 110 before the test head 102 is to contact the DUT 110. In some examples, the arm 122 is positioned at an angle relative to the first surface 112 of the DUT 110. In some examples, the arm 122 contacts a stiffener associated with the DUT 110 or an IHS associated with the DUT 110.

In FIG. 1C, the example tool system 100 is shown in a third or engaged position. The example test head 102 and the example mounting piece 104 have moved further in the direction indicated by the arrow 126. Thus, the example test head 102 is in contact with the second surface 114 of the DUT 110. In some examples, the example test head 102 thermally interfaces with the DUT 110.

The example first push off tab 106 is held in compression between the mounting piece 104 and the first surface 112. As shown in FIG. 1C, an example outline 128 illustrates a shape of the first push off tab 106 prior to the test head 102 contacting the DUT 110. For example, the outline 128 illustrates the shape of the first push off tab 106 in the first position of FIG. 1A and/or the second position of FIG. 1B. In the third position of FIG. 1C, the shape of the example first push off tab 106 changes in compression. For example, an example end 130 (e.g., tip) of the first push off tab 106 in the engaged position is displaced (e.g., vertically displaced) by an example distance 132 from the outline 128 of the first or second position. In some examples, the distance 132 is between 0.5 millimeters (mm) and 1 mm. In the illustrated examples, the arm 122 is shown as being substantially straight both before and after it is placed in compression. However, in some examples, the arm 122 pinches, curves, bends, and/or otherwise deforms when compressed (at the position in FIG. 1C) relative to the uncompressed state (at the position in FIGS. 1A and 1B). Further, in some examples, the arm 122 is designed to be curved, tapered, or bent along its length when in the uncompressed state.

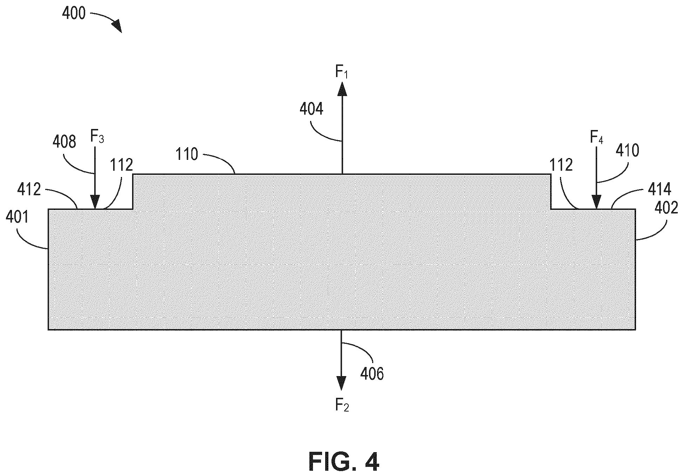

The example first push off tab 106 has at least some stiffness and/or spring-like behavior. For example, the first push off tab 106 includes materials that are compressible, resilient, spring-like, stiff, etc. As such, the example first push off tab 106 resists the compressive force exerted by the DUT 110. This resistance causes the example first push off tab 106 to exert a reactionary force against the DUT 110 (e.g., via the arm 122). As shown in FIG. 1C, the example first push off tab 106 creates a reactionary force on the DUT 110, as described in detail in connection with at least FIG. 4.

In FIG. 1D, the example tool system 100 is shown in a fourth or disengaged position. As shown in FIG. 1D, the example mounting piece 104 and the test head 102 move away from the DUT 110 and the socket 108 in a direction indicated by arrow 134. However, the example arm 122 remains in contact with the DUT 110 after the test head 102 is removed from contacting the DUT 110. Additionally, the example reactionary force continues to push against the DUT 110 (e.g., as the mounting piece 104 moves away from the socket 108/DUT 110). In this manner, the reactionary force exerted by the arm 122 retains a position (e.g., a vertical position) of the DUT 110 after the test head 102 is decoupled from the DUT 110 (e.g., the second surface 114 of the DUT 110). In other words, the example arm 122 limits and/or blocks the DUT 110 from moving with the test head 102 in the direction indicated by the arrow 134 (e.g., due to adhesion between corresponding surfaces). In other words, the reactionary force on the DUT 110 produced by the arm 122 pushes the DUT 110 away from the test head 102 as the test head is moved away from the socket 108. In some examples, the reactionary force is between about 600 grams force (gf) (e.g., within +/- 50 gf) and 3000 gf.

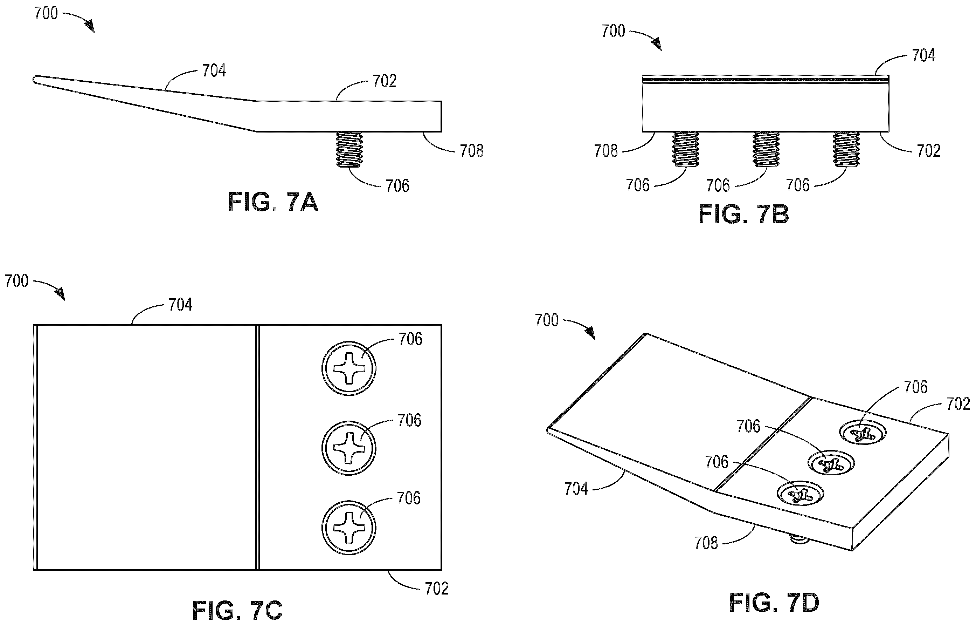

In FIG. 1E, the example tool system 100 returns to the first position of FIG. 1A. As shown, the example first push off tab 106 has returned to its original shape. Further, the example DUT 110 has retained its original position. In FIGS. 1A-1E, only a portion of the tool system 100 is shown for purposes of explanation. However, any of the examples described in connection with 1A-1E can be performed at any location on the tool system 100 as described in connection with at least FIGS. 7A-7C.

FIGS. 2A-2D illustrate the example first push off tab 106 in the example tool system 100 of FIGS. 1A-1E. The example first push off tab 106 includes the body 116, the arm 122, and example posts 200. The example first push off tab 106 includes three posts 200. However, the first push off tab 106 can include any number of the posts 200 (e.g., one, two, four, etc.). The example posts 200 extend away from the third surface 118 (e.g., the third surface 118 to contact the mounting piece 104). The example posts 200 are to couple the first push off tab 106 to the mounting piece 104. For example, the posts 200 are press fit into corresponding receiving holes in the mounting piece 104. In some examples, the posts 200 have a hollow interior to reduce the rigidity of the posts 200 to facilitate insertion and removal into the receiving holes. In other examples, the posts 200 are solid. As such, the example first push off tab 106 is removably coupled to the mounting piece 104 by press fit connection(s). In some examples, the first push off tab 106 is coupled to the mounting piece 104 by snap fit connection(s).

The example first side 201 extends between (e.g., connects) the third and fourth surfaces 118, 120. Additionally, the example arm 122 is positioned at an angle relative to the first side 201 of the body 116. The example arm 122 includes the example end 130 that is distal to the body 116. Further, the example arm 122 includes an example base 202 that is proximal to the body 116. As shown in at least FIG. 2A, the example end 130 includes a first thickness 204 and the base 202 includes a second thickness 206, the second thickness 206 greater than the first thickness 204. In some examples, the first thickness 204 and/or the second thickness 206 is based on a force output of the first push off tab 106 on the DUT 110. As shown in at least FIG. 2C, the example body 116 extends a first length 208 (e.g., in a direction along the mounting piece 104). Further, the example arm 122 extends a second length 210 (e.g., in the direction along the mounting piece 104), the second length 210 less than the first length 208. In other examples, the second length 210 is equal to the first length 208. Further, the example arm 122 extends a third length 211 away from the first side 201 of the body 116. In some examples, the third length 211 is greater than, less than, or about the same as (e.g., within +/- 0.100 nanometers (nm)) the second length 210. The example body 116 includes the first length 208 and an example width 212, the first length 208 greater than the width 212. In other examples, the first length 208 is less than or equal to the width 212. In some examples, the third length 211 is greater than, less than, or about the same as the width 212.

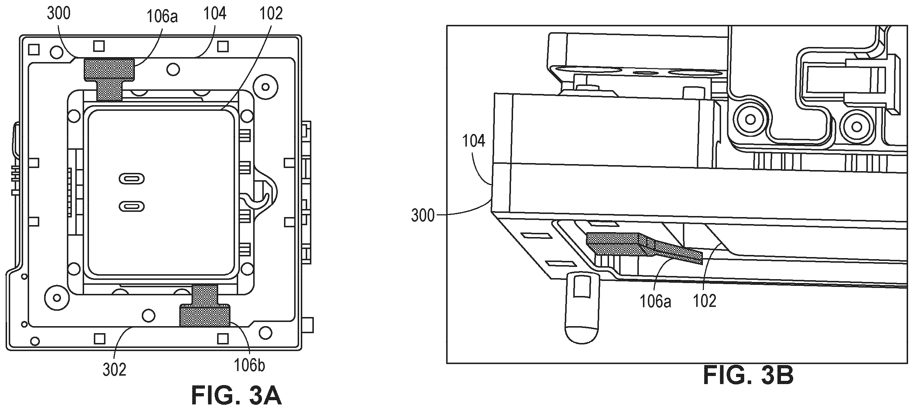

FIG. 3A is a plan view of the example test head 102, the example mounting piece 104, and two example first push off tabs 106a, 106b of FIGS. 1A-1E. The plan view of FIG. 3A displays a bottom-up view of an underside of the mounting piece 104 (e.g., the underside of the mounting piece 104 to face the socket 108). FIG. 3B is a partial, perspective view of the example test head 102, the example mounting piece 104, and the example first push off tab 106a shown in FIG. 3A. The example first push off tab 106a is mounted on an example first edge 300 of the mounting piece 104 and the first push off tab 106b is mounted on an example second edge 302 of the mounting piece 104 opposite to the first edge 300. As such, the example first push off tab 106a is positioned to contact the DUT 110 (FIGS. 1A-1E) adjacent an example first sidewall 401 (FIG. 4) of the DUT 110. Further, the first push off tab 106b is positioned to contact the DUT 110 adjacent an example second sidewall 402 (FIG. 4) of the DUT 110, the second sidewall 402 different from (e.g., opposing) the first sidewall 401. The example first push off tab 106a creates a first reactionary force on the DUT 110 (e.g., adjacent the first sidewall 401) and the second push off tab 106b creates a second reactionary force on the DUT 110 (e.g., adjacent the second sidewall 402), as described in detail in connection with FIG. 4. In some examples, the first push off tab 106a includes a first material (e.g., metal) and the first push off tab 106b includes a second material (e.g., plastic) different from the first material. In some examples, the first push off tab 106a and the first push off tab 106b include a same material. In some examples, another first push off tab 106 can replace either the first push off tab 106a or the first push off tab 106b. In some examples, a replacement push off tab can provide a reactionary force that is different from (e.g., greater than or less than) the reactionary force provided by either the first push off tab 106a or the first push off tab 106b. In some examples, the different reactionary forces provided by different push off tabs are based on at least one of (i) a shape of the replacement push off tab related to the original push off tab (e.g., the first push off tab 106a) or (ii) a material of the original push off tab relative to a material of the replacement push off tab. For instance, a push off tab composed of a more rigid material would provide a greater reaction force when compressed than a push off tab composed of a less rigid material. Further, a push off tab with a thicker arm 122 will resist deformation more readily and, thus, produce a greater reactionary force than a push off tab with a thinner arm 122. Other aspects of the shape or design of different push off tabs (e.g., length of the arm 122, width of the arm 122, shape of the arm 122, curvature of the arm 122, extent the arm 122 gets thinner between the base and its free end, angle of the arm 122 relative to the body 116, etc.) can be modified to tune or adjust the reactionary force produced when the arm 122 is compressed and pressing against the DUT 110. In some examples, any number (e.g., one, two, three, etc.) of the first push off tabs 106 can be mounted on the mounting piece 104.

FIG. 4 is an example free body diagram 400 of the DUT 110 of FIGS. 1A-1E. In particular, the example free body diagram 400 illustrates the forces acting on the DUT 110, including forces due to the first push off tabs 106a, 106b as described in connection with FIGS. 3A and 3B. The example free body diagram 400 includes an example first force vector (F₁) 404, an example second force vector (F₂) 406, an example third force vector (F₃) 408, and an example fourth force vector (F₄) 410. The example first force vector 404 illustrates a direction and magnitude associated with the capillary forces that the test head 102 (FIGS. 1A-1E) exerts on the DUT 110 as the test head 102 moves away from the socket 108 (in the direction of the arrow 134 in FIGS. 1 D and 1E). As used herein, the term "capillary" refers to the adhesion, sticking, etc., between the second surface 114 of the DUT 110 and the test head 102. The example second force vector 406 illustrates a direction and magnitude associated with a mass (e.g., weight, force due to gravity, etc.) of the DUT 110. The example third force vector 408 illustrates a direction and magnitude associated with a force applied by the first push off tab 106a on a first portion 412 of the first surface 112 of the DUT 110 (e.g., the first portion 412 of the first surface 112 adjacent the first sidewall 401). Additionally, the example fourth force vector 410 illustrates a direction and magnitude associated with a force applied by the first push off tab 106b on a second portion 414 of the first surface 112 of the DUT 110 (e.g., the second portion 414 of the first surface 112 adjacent the second sidewall 402). In some examples, the first and second push off tabs 106a, 106b are designed so that the third force vector 408 is approximately equal to the fourth force vector 410 to provide an even or symmetrical distribution of forces from the first and second push off tabs 106a, 106b acting on the DUT 110.

To maintain a position of the DUT 110 within the socket 108 as the test head 102 separates from the socket 108 and, thus, the DUT 110 (e.g., the disengaged position of FIG. 1D), the force applied by each of the first push off tabs 106a, 106b and the weight of the DUT 110 exceeds the capillary force due to the removal of the test head 102 (e.g., (F₂ + F₃ + F₄) > F₁). In some examples, the DUT 110 is removed/displaced from the socket 108 when the capillary force due to the removal of the test head 102 exceeds the force applied by the first push off tabs 106a, 106b and the weight of the DUT 110 (e.g., F₁ > (F₂ + F₃ + F₄)). Accordingly, by using different push off tabs (e.g., having different sizes, shapes, and/or material properties), different reactionary forces (e.g., F₃, F₄) can be achieved that are adapted to the particular capillary forces (F₁) and force of gravity (F₂) associated with different DUTs.

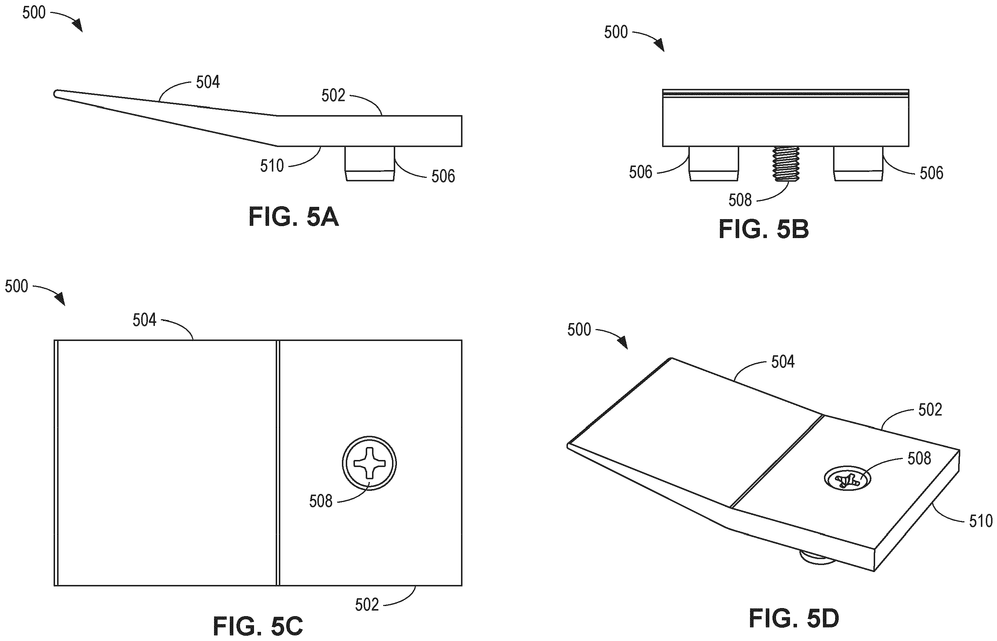

FIGS. 5A-5D illustrate an example second push off tab 500 that can be implemented in the example tool system 100 of FIGS. 1A-1E. The example second push off tab 500 of FIGS. 5A-5D is similar to the example first push off tab 106 of FIGS. 1A-2D. For example, the second push off tab 500 includes an example body 502, an example arm 504, and example posts 506. However, the example second push off tab 500 includes an example threaded fastener 508 extending away from an example surface 510 of the second push off tab 500. In this example, the surface 510 is to contact the mounting piece 104. The example threaded fastener 508 couples to a corresponding threaded opening in the mounting piece 104. As such, the example second push off tab 500 is removably coupled (e.g., at least in part) to the mounting piece 104 by the threaded fastener 508. The example posts 506 are snap fitted or press fitted into corresponding receiving holes in the mounting piece 104 to couple the second push off tab 500 to the mounting piece 104. In some examples, the posts 506 can be retained within the receiving holes by a loose fit (e.g., not press fitted) such that the posts merely serve to prevent the second push off tab 500 from rotating about the axial length of the threaded fastener 508 while the threaded fastener 508 functions to hold the tab against the mounting piece 104 (e.g., prevent movement of the tab 500 in a direction along the axial length of the threaded fastener 508). The example second push off tab 500 includes two posts 506. However, the second push off tab 500 can include any number of the posts 506 (e.g., one, three, four, etc.). In some examples, the threaded fastener 508 and the posts 506 are arranged differently than as shown in FIGS. 5A-5D.

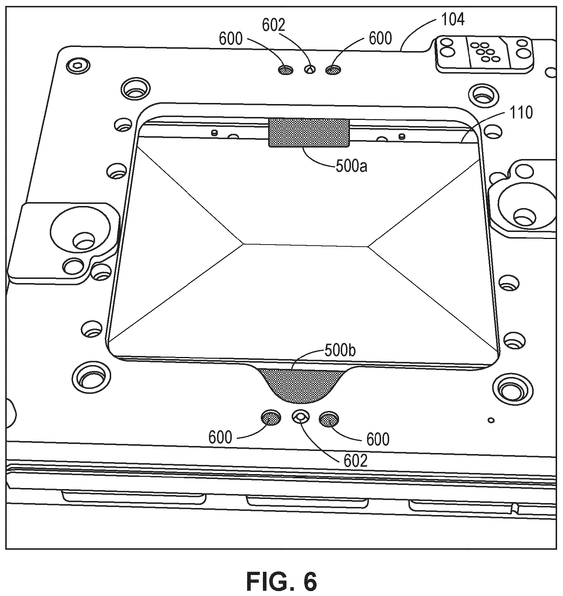

FIG. 6 is a perspective view of the example mounting piece 104, the DUT 110 of FIGS. 1A-1E, and two second push off tabs 500a, 500b of FIGS. 5A-5D. The plan view of FIG. 3A displays a bottom-up view of an underside of the mounting piece 104 (e.g., the underside of the mounting piece 104 to face the socket 108). Contrarily, the perspective view of FIG. 6 displays a top-down view of a topside of the mounting piece 104 (e.g., the topside of the mounting piece 104 to face away from the socket 108). In the example of FIG. 6, the two example second push off tabs 500a, 500b are mounted to the mounting piece 104. Further, the example mounting piece 104 includes example holes 600 and example threaded openings 602. The example holes 600 are positioned to receive the posts 506 (FIGS. 5A-5D) associated with each of the second push off tabs 500a, 500b. Further, the example threaded openings 602 or positioned to receive the threaded fasteners 508 (FIGS. 5A-5D) associated with each of the second push off tabs 500a, 500b. As such, the second push off tabs 500a, 500b are mounted to the mounting piece 104 via press fit connections between the holes 600 and the posts 506. Further, the second push off tabs 500a, 500b are mounted to the mounting piece 104 via threaded connections between the threaded openings 602 and the threaded fasteners 508.

FIGS. 7A-7D illustrate an example third push off tab 700 that can be implemented in the example tool system 100 of FIGS. 1A-1E. The example third push off tab 700 of FIGS. 7A-7D is similar to the example second push off tab 500 of FIGS. 5A-5D. For example, the third push off tab 700 includes an example body 702 and an example arm 704. However, the example third push off tab 700 includes three example threaded fasteners 706 extending away from an example surface 708 of the third push off tab 700 (e.g., the surface 708 to contact the mounting piece 104). The example threaded fasteners 706 couple to corresponding threaded openings in the mounting piece 104.

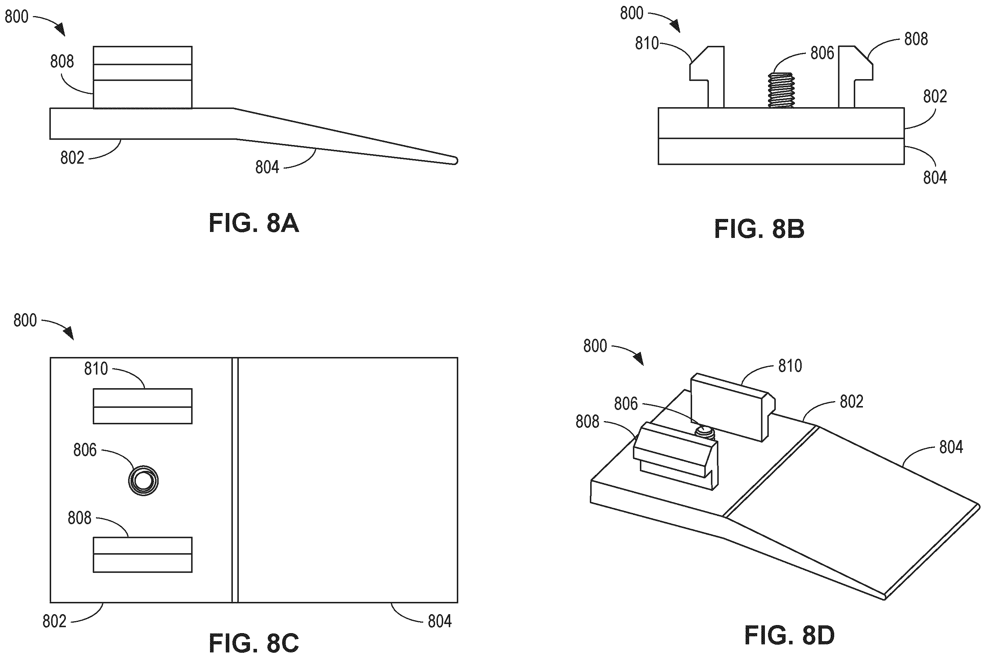

FIGS. 8A-8D illustrate an example fourth push off tab 800 that can be implemented in the example tool system 100 of FIGS. 1A-1E. The example fourth push off tab 800 of FIGS. 8A-8D is similar to the example second push off tab 500 of FIGS. 5A-5D. For example, the fourth push off tab 800 includes an example body 802, an example arm 804, and an example threaded fastener 806. However, instead of the example posts 506 (FIGS. 5A-5D), the fourth push off tab 800 includes example wedge components 808, 810. The example wedge components 808, 810 extend away from an example surface 812 of the fourth push off tab 800 (e.g., the surface 812 to contact the mounting piece 104). The example threaded fastener 806 is positioned between the wedge components 808, 810 along the surface 812. The example wedge components 808, 810 are to snap fit into corresponding receiving openings in the mounting piece 104. As such, the example fourth push off tab 800 is coupled to the mounting piece 104 via a snap fit connection (via the wedge components 808, 810) and/or a threaded connection (via the threaded fastener 806). In the example of FIGS. 8A-8D, the fourth push off tab 800 includes two wedge components 808, 810. However, the fourth push off tab 800 can include any number of wedge components (e.g., one, three, four, etc.). In some examples, the threaded fastener 806 is omitted from the fourth push off tab 800. In some examples, any of the posts 200, 506 are used in combination with either of the wedge components 808, 810 (e.g., with or without one or more threaded fasteners).

In the example of FIGS. 5A-5D, the second push off tab 500 includes one threaded fastener 508. In the example of FIGS. 7A-7D, the third push off tab 700 includes three threaded fasteners 706. In the example of FIGS. 8A-8D, the fourth push off tab 800 includes one threaded fastener 806. However, the second push off tab 500, the third push off tab 700, or the fourth push off tab 800 can include any number of threaded fasteners (e.g., one, two, three, four, etc.). Further, any of the example fasteners disclosed herein (e.g., the threaded fastener 508, the threaded fasteners 706, or the threaded fastener 806) can be arranged, positioned, oriented, etc., differently than as shown.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example, an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that retain a positioning of an example DUT during thermal testing and/or immediately thereafter as a test head is being removed. For example, as an example test head disengages, separates, etc., from a socket containing the DUT during an example test, example push off tabs disclosed herein create a reactionary force against any adhesive/capillary forces. As such, examples disclosed herein improve the efficiency of a testing sequence by mitigating manual intervention that is otherwise needed to separate the DUT from the test head. Further, example push off tabs disclosed herein can be quickly and easily replaced on a given test head with different push off tabs of different sizes, shapes, and/or other properties as needed to be used with different types of DUTs having varying dimensions, positions, etc. As such, examples disclosed herein are cost effective and improve the overall efficiency of the testing sequence.

Example 1 includes an apparatus comprising a test head to thermally interface with an integrated circuit (IC) device, a mounting piece to be coupled to the test head, and a push off tab to be mounted to the mounting piece, the push off tab including an arm to extend underneath the test head, the arm to contact the IC device before the test head is to contact the IC device.

Example 2 includes the apparatus of example 1 wherein the arm is to extend towards the IC device.

Example 3 includes the apparatus of any of example 1 or example 2, where the IC device includes a first surface and a second surface, the first surface recessed relative to the second surface, the arm to contact the first surface, the test head to contact the second surface.

Example 4 includes the apparatus of any of examples 1-3, wherein the arm is positioned at an angle relative to the first surface.

Example 5 includes the apparatus of any of examples 1-4, wherein the push off tab is held in compression between the test head and the first surface.

Example 6 includes the apparatus of any of examples 1-5, wherein the push off tab includes a tab body having a side extending between opposing third and fourth surfaces, the third surface in contact with the mounting piece, the arm extending from the side of the tab body.

Example 7 includes the apparatus of any of examples 1-6, wherein the push off tab includes a post extending away from the third surface, the post to couple the push off tab to the mounting piece.

Example 8 includes the apparatus of any of examples 1-7, wherein the arm includes a tip that is distal to the tab body and a base that is proximal to the tab body, the tip having a first thickness and the base having a second thickness, the second thickness greater than the first thickness.

Example 9 includes the apparatus of any of examples 1-8, wherein the push off tab is removably couplable to the mounting piece.

Example 10 includes the apparatus of any of examples 1-9, wherein the push off tab is removably couplable to the mounting piece by a threaded fastener.

Example 11 includes the apparatus of any of examples 1-10, wherein the push off tab is removably couplable to the mounting piece by a press fit connection.

Example 12 includes the apparatus of any of examples 1-11, wherein the push off tab is removably couplable to the mounting piece by a snap fit connection.

Example 13 includes the apparatus of any of examples 1-12, wherein the push off tab is a first push off tab positioned to contact a first portion of a first surface of the IC device, the first portion adjacent a first sidewall of the IC device, further including a second push off tab mounted to the mounting piece, the second push off tab positioned to contact a second portion of the first surface, the second portion adjacent a second sidewall of the IC device, the second sidewall different from the first sidewall.

Example 14 includes the apparatus of any of examples 1-13, wherein the second push off tab is to replace the first push off tab, the first push off tab to create a first reactionary force on the IC device and the second push off tab to create a second reactionary force on the IC device, the second reactionary force different from the first reactionary force based on a difference in at least one of (i) a shape of the second push off tab relative to the first push off tab or (ii) a material of the second push off tab relative to a material of the first push off tab.

Example 15 includes a tab to exert a force on an integrated circuit (IC) device, the tab comprising a body to interface with a mounting plate, the mounting plate included in a tool configured to thermally test the IC device, and a cantilevered arm extending from a side of the body, the cantilevered arm positioned at an angle relative to the side of the body, the tab to exert a force on the IC device via the cantilevered arm.

Example 16 includes the tab of example 15, wherein the cantilevered arm is to contact the IC device prior to the tool contacting the IC device, and the cantilevered arm is to remain in contact with the IC device after the tool is removed from contacting the IC device.

Example 17 includes the tab of example 15 or example 16, wherein the body is coupled to the mounting plate, the body to extend a first length in a direction along the mounting plate, the cantilevered arm to extend a second length in the direction, the second length less than the first length.

Example 18 includes a tool system comprising a first tool, the first tool movable to thermally couple to an integrated circuit (IC) device, a second tool movable with the first tool, and a push off tab supported by the second tool to move with the first and second tools, the push off tab to retain a position of the IC device within a socket after the first tool is decoupled from the IC device.

Example 19 includes the tool system of example 18, wherein the push off tab is a first push off tab, further including a second push off tab to replace the first push off tab.

Example 20 includes the tool system of example 18 or example 19, wherein the first push off tab includes a first material and the second push off tab includes a second material, the second material different from the first material.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An apparatus comprising:
a test head to thermally interface with an integrated circuit (IC) device;
a mounting piece to be coupled to the test head; and
a push off tab to be mounted to the mounting piece, the push off tab including an arm to extend underneath the test head, the arm to contact the IC device before the test head is to contact the IC device.

2. The apparatus of claim 1, wherein the arm is to extend towards the IC device.

3. The apparatus of any one of claims 1-2, where the IC device includes a first surface and a second surface, the first surface recessed relative to the second surface, the arm to contact the first surface, the test head to contact the second surface.

4. The apparatus of claim 3, wherein the arm is positioned at an angle relative to the first surface.

5. The apparatus of any one of claims 3-4, wherein the push off tab is held in compression between the test head and the first surface.

6. The apparatus of any one of claims 1-5, wherein the push off tab includes a tab body having a side extending between opposing third and fourth surfaces, the third surface in contact with the mounting piece, the arm extending from the side of the tab body.

7. The apparatus of claim 6, wherein the push off tab includes a post extending away from the third surface, the post to couple the push off tab to the mounting piece.

8. The apparatus of any one of claims 6-7, wherein the arm includes a tip that is distal to the tab body and a base that is proximal to the tab body, the tip having a first thickness and the base having a second thickness, the second thickness greater than the first thickness.

9. The apparatus of any one of claims 1-8, wherein the push off tab is removably couplable to the mounting piece.

10. The apparatus of claim 9, wherein the push off tab is removably couplable to the mounting piece by a threaded fastener.

11. The apparatus of claim 9, wherein the push off tab is removably couplable to the mounting piece by a press fit connection.

12. The apparatus of claim 9, wherein the push off tab is removably couplable to the mounting piece by a snap fit connection.

13. The apparatus of any one of claims 1-12, wherein the push off tab is a first push off tab positioned to contact a first portion of a first surface of the IC device, the first portion adjacent a first sidewall of the IC device, further including a second push off tab mounted to the mounting piece, the second push off tab positioned to contact a second portion of the first surface, the second portion adjacent a second sidewall of the IC device, the second sidewall different from the first sidewall.

14. The apparatus of claim 13, wherein the second push off tab is to replace the first push off tab, the first push of tab to create a first reactionary force on the IC device and the second push off tab to create a second reactionary force on the IC device, the second reactionary force different from the first reactionary force based on a difference in at least one of (i) a shape of the second push off tab relative to the first push off tab or (ii) a material of the second push off tab relative to a material of the first push off tab.

15. The apparatus of any one of claims 1-14, wherein the push off tab includes a body, the push off tab to be coupled to the mounting piece via the body, the arm extending from the body, the body to extend a first length in a direction along the mounting piece, the arm to extend a second length in the direction, the second length less than the first length.
